# EUROPEAN PATENT APPLICATION

(11) **EP 2 887 782 A1**
(43) Date of publication of application: **24.06.2015**
(21) Application number: 13005971.0
(22) Date of filing: 20.12.2013
(51) Int. Cl.: H05K 7/14, G06F 1/30, H02J 9/06, H02B 1/20

(54) **Switchgear assembly and power distribution system**

(71) Applicant: ABB AG, 68309 Mannheim (DE)
(72) Inventor: Forstbach, Matthias, 64683 Einhausen (DE); Merkel, Hans-Peter, 69198 Schriesheim (DE)

(57) **Abstract**

The invention relates to an UPS switchboard module (8) for use in a switchgear assembly (1) for DC power distribution, comprising:
- a number of withdrawable battery feed units (81) including a breaker for selectively coupling a respective battery unit (82) with a DC power distribution bus (3);
- a cabling unit (83) for coupling each of the battery feed units (81) with the re-spective battery unit (82).

## Description

### Technical field

The present invention relates to power distribution systems for supplying DC power to a consumer load, in particular for a DC data center. The power distribution system comprises modularized device cabinets including a main breaker module and a power converter module and the like.

### Related art

Commonly, electrical switchgear assemblies for power applications are designed using modularized devices, such as processing, controlling, measuring and switching devices that are arranged on or in modularized withdrawable parts and/or exchangeable cabinets or cubicles. Withdrawable parts allows for a simplified access in case of a fault or maintenance activities as the part in question can easily be removed from the module or cabinet and separately checked, repaired or exchanged without any essential dismantling work.

Generally, in switchgear applications the power is received, converted and distributed via modules or cabinets to the consumer load. In particular for common data center arrangements a battery backup will be provided to buffer a loss of the AC power supply until the power generator or the general grid will feed the switchgear assembly again.

Depending on the specific application, common switchgear assemblies comprise a switch/breaker cabinet, an UPS (uninterruptable power supply) unit in one or more separate cabinets, and the distribution of the AC or DC power to the consumer load via a respective distribution board. Conventionally, the batteries of the UPS may be directly connected to the power converter modules/cabinets in/via the UPS unit. Such a configuration requires separate switchboards with cable or bus duct connections in between. In a DC distribution setup the batteries are directly connected to the DC bus, so that the batteries need stand-alone switchgears to be connected.

Hence, such an assembly has disadvantages as it requires a higher engineering, commissioning and maintenance effort. Furthermore, the cost and energy losses due to the cabling and the additionally required breaker are high. With respect to data centers, however, the power conversion and thermal losses should be significantly reduced and it is desirable to render them more energy-efficient.

It is therefore an object of the present invention to provide a power distribution system for a switchgear assembly for providing a DC power distribution which is secured by UPS units and batteries which ensure a high flexibility and reliability while having a reduced complexity. Furthermore, the power distribution system shall provide a reduced installation and operation effort.

### Summary of the invention

This object has been achieved by the UPS switchboard module according to claim 1, the switchgear assembly and the power distribution system according to the further independent claims.

Further embodiments and refinements are indicated in the dependent subclaims.

According to a first aspect a UPS switchboard module for use in a switchgear assembly for DC power distribution is provided, comprising:
- a number of withdrawable battery feed units including a breaker for selectively coupling a respective battery unit with a DC power distribution bus; and
- a cabling unit for coupling each of the battery feed units with the respective battery unit.

According to one idea of the above UPS switchboard module a separate module/cabinet for coupling a DC power distribution bus to a UPS battery power source shall be provided. Using the UPS switchboard module, an adaptable number of battery units of various customized characteristics can be coupled to the DC power distribution bus depending on the required power of the coupled consumer loads. Hence, the UPS switchboard module allows for coupling all required battery units to provide a specific battery capacity in the power distribution system of the switchgear assembly, e. g. in a data center.

The UPS switchboard module/cabinet includes battery feed units with a breaker which can be replaced or withdrawn from the UPS switchboard module, so that the switchboard module can be customized/dimensioned according to given requirements. With such a configuration of the UPS switchboard module, the maintenance and exchange of battery feed units is rendered much more flexible and the downtime can be reduced to a minimum.

Moreover, the UPS switchboard module further comprises AC supply bus bars for forming an AC supply bus with AC supply bus bars of one or more other coupled modules.

Additionally or alternatively, the UPS switchboard module further comprises DC power distribution bus bars for forming the DC power distribution bus with DC power distribution bus bars of one or more other coupled modules, particularly of one or more AC/DC converter modules

It may be provided that the AC supply bus bars and the DC power distribution bus bars are configured to be electrically couplable with AC supply bus bars and the DC power distribution bus bars of the one or more other coupled modules, respectively.

According to an embodiment, the UPS switchboard module may form a separate cabinet or cubicle.

Each of the battery units may be included in the separate cabinet of the UPS switchboard module or provided as an external cubicle.

According to a further aspect a switchgear assembly is provided, comprising:
- a main breaker module including a general circuit breaker for switching an AC supply bus;
- one or more AC/DC converter modules for converting AC power from the AC supply bus to DC power onto a DC power distribution bus ; and
- the above a UPS switchboard module.

According to a further aspect a power distribution system for a switchgear assembly is provided including:
- AC supply bus for providing an AC power supply;
- a DC power distribution bus for providing DC power;
- a general circuit breaker for switching the AC supply bus;
- one or more AC/DC converter units for converting AC power from the AC supply bus to DC power onto the DC power distribution bus;
- a number of withdrawable battery feed units each including a breaker for selectively coupling a respective battery unit with the DC power distribution bus; and
- a cabling unit for coupling each of the battery feed units with the respective battery unit.

### Brief description of the drawings

Embodiments are described in more detail in conjunction with the accompanying drawings in which:

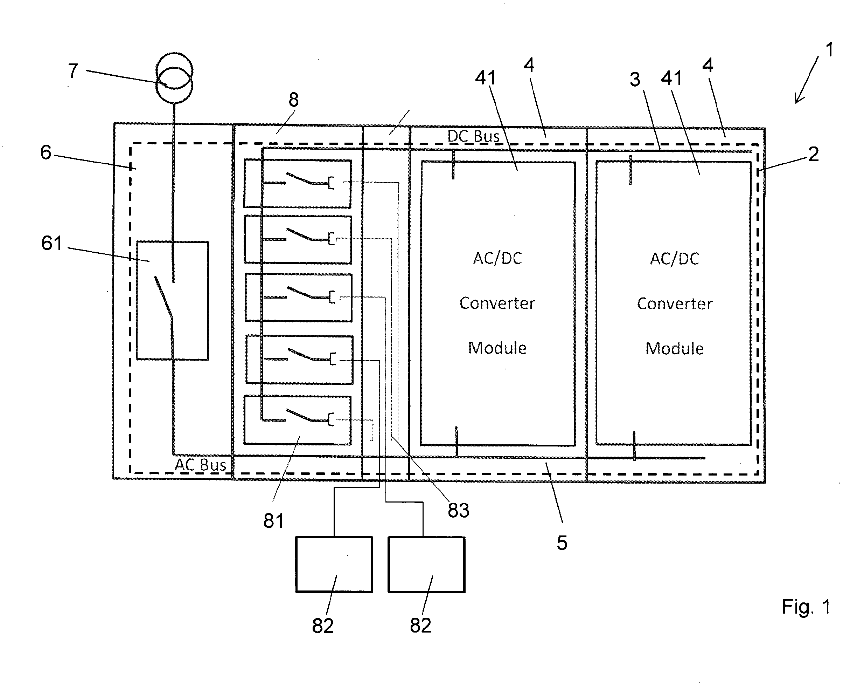

- Fig. 1: schematically shows a switchgear assembly with a DC power distribution system and a UPS switchboard module.

### Description of embodiments

Figure 1 schematically shows an exemplary embodiment of a switchgear assembly 1 including a power distribution system 2 providing DC power to a DC consumer load (not shown), in particular for a DC data center. The switchgear assembly 1 comprises a number of modules or cabinets arranged side by side which are electrically connected to each other.

Furthermore, the DC power is distributed via a DC power distribution bus 3. The DC power distribution bus 3 is formed by DC power distribution bus bars passing through cabinets coupled side by side.

To the DC power distribution bus 3 DC power is supplied by one or more AC/DC converter units 41 that are included in separated AC/DC converter modules 4. The AC/DC converter modules 4 each include AC distribution bus bars which are electrically coupled forming an AC power supply bus 5 via which AC power is distributed to each of the AC/DC converter units 41. The AC/DC converter units 41 are config-ured to convert the AC power into DC power and to supply the DC power to the DC power distribution bus 3.

The AC power supply bus 5 may include at least one AC power supply bus bar per phase. A bus bar may be understood as any type of electrical conductor that is applicable to be used in a switchboard or switchgear assembly and is not limited to or restricted by a specific geometry. A bus bar may also comprise an electrical conductor bundle or conductor assembly. The DC power distribution bus 3 also comprises one bus bar per Dc potential provided.

A main breaker module 6 or main breaker cabinet is provided which is configured to connect with an AC power source or power supply 7 and to switchably supply the so received AC power to the AC power supply bus 5. The main breaker module 6 comprises an AC circuit breaker 61 which is serially connected between the AC power supply 7 and the AC power supply bus 5. The general AC circuit breaker 61 is integrated in the switchgear assembly 1 and part of the main breaker module 6.

Furthermore, a UPS switchboard module 8 or a UPS switchboard cabinet is provided which represents a separate module to be combined with the main breaker module 6 and the AC/DC converter modules 4. The UPS switchboard module 8 includes battery feed units 81 each representing a breaker for the connection/coupling of a UPS battery unit 82 with the DC power distribution bus bars of the DC power distribution bus 3 which are connected with the DC power distribution bus bars of the AC/DC converter modules 4.

The UPS battery units 82 are connected with the respective battery feed units 81 via a cabling unit 83 which may be part of the UPS switchboard module 8 or provided in a separated module. This allows the battery units 82 to be connected via an integrated cabinet with the advantage of a separate line/load side connection of the battery units 82 via the breakers of the battery feed units 81.

The battery units 82 can be integrated in the UPS switchboard module 8 or be arranged separately.

By selecting the number of battery units 82 to be connected to the cabling unit 83, the battery backup system can be adjusted to the needs of the consumer load and it is also possible that each battery unit 82 can be customized/dimensioned according to given requirements.

Even changes and extensions can easily be performed by installing an additional battery feed unit 81 into the UPS switchboard module 8. Therefore, the battery feed units 81 can be provided such that they can be plugged in or withdrawn according to the requirements of the switchgear assembly 1. This configuration allows for rendering the maintenance and exchange of battery feed modules 81 more flexible, so that the downtime of the UPS safety installation can be reduced to a minimum.

## Claims

1. An UPS switchboard module (8) for use in a switchgear assembly (1), in particular a low voltage switchgear assembly, for DC power distribution, comprising:
- a number of withdrawable battery feed units (81) including a breaker for selectively coupling a respective battery unit (82) with a DC power distribution bus (3);
- a cabling unit (83) for coupling each of the battery feed units (81) with the respective battery unit (82).

2. UPS switchboard module (8) according to claim 1, further comprising AC supply bus bars for forming an AC supply bus (5) with AC supply bus bars of one or more other coupled modules.

3. UPS switchboard module (8) according to claim 1 or 2, further comprising DC power distribution bus bars for forming the DC power distribution bus with DC power distribution bus bars of one or more other coupled modules, particularly of one or more AC/DC converter modules

4. UPS switchboard module (8) according to claim 2 or 3, wherein the AC supply bus bars and the DC power distribution bus bars are configured to be electrically couplable with AC supply bus bars and the DC power distribution bus bars of the one or more other coupled modules, respectively.

5. UPS switchboard module (8) according to any of the claims 1 or 4, wherein the UPS switchboard module (8) forms a separate cabinet or cu-bicle.

6. UPS switchboard module (8) according to claim 5, wherein each of the battery units are included in the separate cabinet of the UPS switchboard module (8) or provided as an external cubicle.

7. A switchgear assembly, in particular a low voltage switchgear assembly, comprising:
- a main breaker module including a general circuit breaker for switching an AC supply bus;
- one or more AC/DC converter modules for converting AC power from the AC supply bus to DC power onto a DC power distribution bus ; and
- a UPS switchboard module (8) according to any of the claims 1 to 6.

8. A power distribution system (2) for a switchgear assembly (1), in particular a low voltage switchgear assembly, including:
- AC supply bus (5) for providing an AC power supply;
- a DC power distribution bus (3) for providing DC power;
- a general circuit breaker (61) for switching the AC supply bus (5);
- one or more AC/DC converter units (41) for converting AC power from the AC supply bus (5) to DC power onto the DC power distribution bus (3);
- a number of withdrawable battery feed units (81) each including a breaker for selectively coupling a respective battery unit (82) with the DC power distribution bus (3); and
- a cabling unit (83) for coupling each of the battery feed units (81) with the respective battery unit (82).
